# EUROPEAN PATENT APPLICATION

(11) **EP 2 197 257 A2**
(43) Date of publication of application: **16.06.2010**
(21) Application number: 09252776.1
(22) Date of filing: 14.12.2009
(51) Int. Cl.: H05K 7/20

(54) **Plasma display device**

(30) Priority: 12.12.2008 KR 20080126445
(71) Applicant: Samsung SDI Co., Ltd., Gyeonggi-do (KR)
(72) Inventor: Kim, Ulje, Yongin-si Gyeonggi-do (KR)
(74) Representative: Mounteney, Simon James

(57) **Abstract**

A plasma display device in which noise of an electric signal and uncertainty of a power supply are prevented when a scan IC is packaged using chip-on-film technology. The plasma display device includes: a plasma display panel having pluralities of scan electrodes, sustain electrodes, and address electrodes; a chassis base disposed at the rear of the plasma display panel; a circuit unit insulated from the rear side of the chassis base by bosses and driving the plasma display panel; radiator plates provided at the rear of the circuit unit; chip-on-film (COF) packages formed at the rear of the radiator plates, electrically connecting the scan electrodes to the circuit unit, and including a scan integrated circuit (IC) to drive the circuit unit; and couplers penetrating the COF packages, the radiator plates, and the circuit unit to couple the same with each other.

## Description

### Background of the Invention

### Field of the Invention

An aspect of the present invention relates to a plasma display device and IC packaging.

### Description of the Related Art

A plasma display device refers to a flat panel display displaying an image using a gas discharge phenomenon, and has excellent displaying performance in view of displaying capacity, brightness, contrast, afterimage, viewing angle, and the like.

Generally, the plasma display device includes a plasma display panel, a chassis base parallel to the plasma display panel, a circuit unit provided at the rear of the chassis base to drive the plasma display panel, and a tape carrier package (TCP) or a chip-on-film (COF) package connecting the plasma display panel to the circuit unit. And the TCP or COF package drive the plasma display panel.

### Brief Summary of the Invention

The present invention has been made in view of the above problems, and the present invention provides a plasma display device in which noise of an electric signal and uncertainty of a power supply can be prevented when a scan integrated circuit is packaged using a chip-on-film technology.

In accordance with an embodiment of the present invention, there is provided a plasma display device comprising: a plasma display panel including pluralities of electrodes; a chassis base disposed at one surface of the plasma display panel; a circuit unit insulated from an opposite of the chassis base to the plasma display panel by bosses and driving the plasma display panel; radiator plates provided at an opposite surface of the circuit unit to the chassis base; chip-on-film (COF) packages formed at an opposite surface of the radiator plates to the radiator plates, electrically connecting the scan electrodes to the circuit unit, and including a integrated circuit (IC) to drive the circuit unit; and couplers penetrating the COF packages, the radiator plates, and the circuit unit to couple the same with each other.

Each of the radiator plates may extendto a position where each of the ICs is positioned.

The plasma display device may further comprise conductive connecting members between the radiator plates and the circuit unit.

The conductive connecting members may be made of one selected from a group of a conductive sponge, a copper plate, a steel plate, and a combination thereof.

The circuit unit may comprise at least one line electrically connected to the couplers.

The line of the circuit unit connected to the couplers may be a ground signal line.

Each of the COF packages may comprise at least one line electrically connected to the couplers.

The plasma display device further comprises connectors connected to ends of the COF packages to be electrically connected to the rear side of the circuit unit.

The COF packages may cover the radiator plates.

The radiator plates may be exposed in the direction facing the chassis base.

The couplers may be coupled with the bosses.

The couplers may correspond to the COF packages one by one.

By doing as described above, a plasma display device according to the present invention can include COF packages extended to the rear side of the circuit unit and directly connected to the circuit unit through the couplers such that ground signals can be transmitted to the COF packages stably.

The radiator plates extending to the lower sides of the scan ICs enable easy radiation of heat from the scan ICs and can be covered with the COF packages so as not to be exposed to the exterior such that a user can be protected from the radiator plates to which the high voltage is supplied.

The above and other features of the invention are set out in the appended claims.

### Brief Description of the Drawings

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:

FIG. 1 is a perspective view illustrating a plasma display device according to an embodiment of the present invention;

FIG. 2 is an enlarged perspective view of a portion 'A' in FIG. 1;

FIG. 3 is an enlarged plan view of the portion 'A' in FIG. 1; and

FIG. 4 is a sectional view taken along the ling B-B in FIG. 2.

### Detailed Description of the Invention

The following detailed description refers to the accompanying drawings which form a part hereof, and in which is shown by way of illustration specific examples in which the disclosure may be practiced. These examples are discussed in sufficient detail to enable those skilled in the art to practice the teachings of the disclosure.

Hereinafter, a plasma display device 100 according to an embodiment of the present invention will be described.

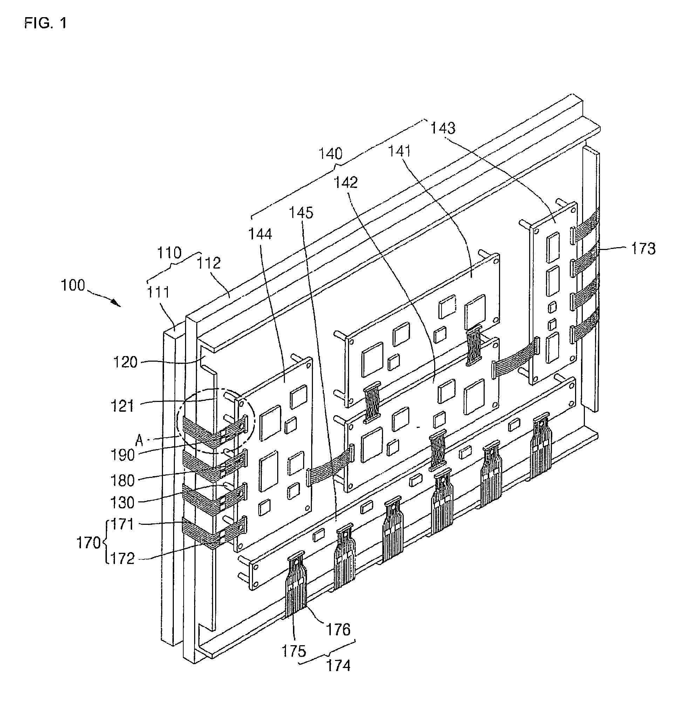

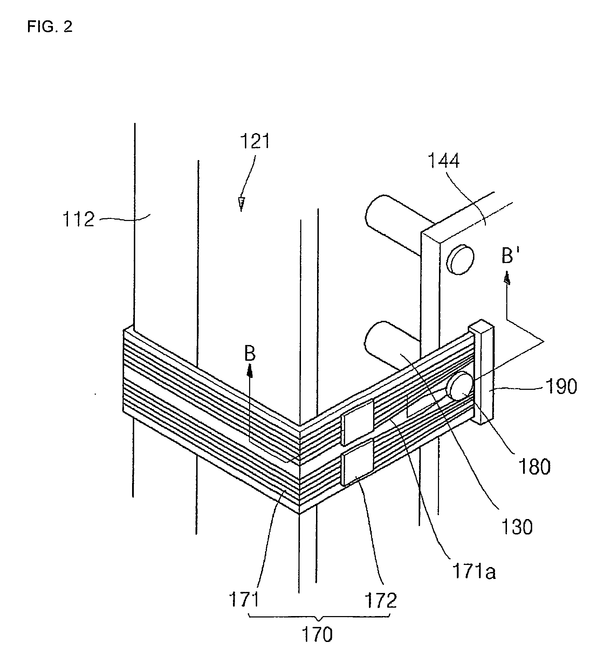

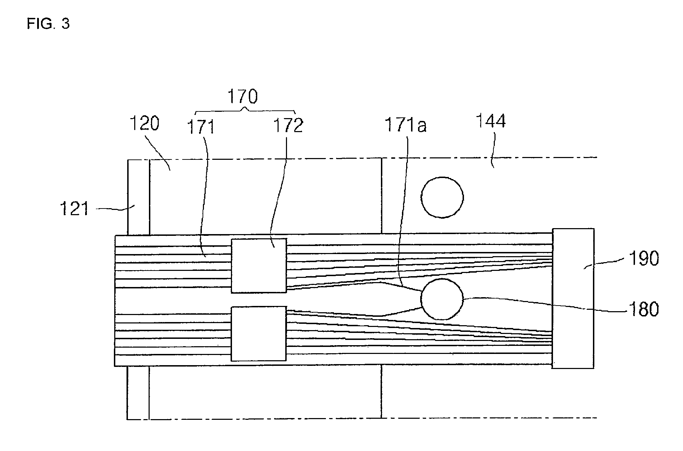

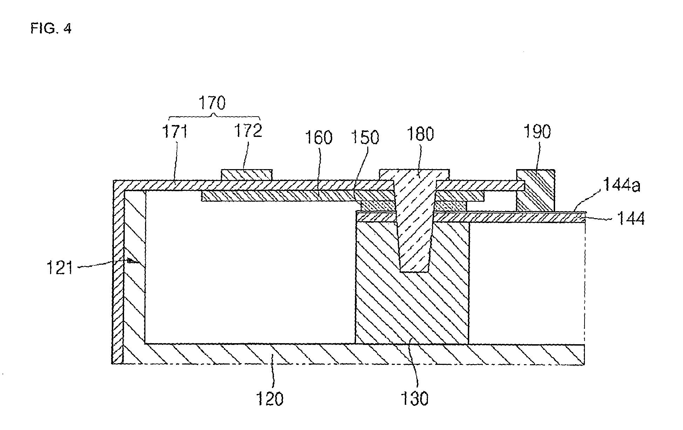

FIG. 1 is a perspective view illustrating the plasma display device 100, FIG. 2 is an enlarged perspective view of a portion 'A' in FIG. 1, FIG. 3 is an enlarged plan view of the portion 'A' in FIG. 1, and FIG. 4 is a sectional view taken along the line B-B' in FIG. 2.

Referring to FIGS. 1 to 4, the described plasma display device 100 according to the present invention includes a plasma display panel 110, a chassis base 120 positioned at the rear of the plasma display panel 110, bosses 130 protruding from the rear side of the chassis base 120, a circuit unit 140 provided at the rear of the bosses 130, radiator plates 160 positioned at the rear of the circuit unit 140, chip-on-film (COF) packages 170 formed at the rear of the radiator plates 160, couplers 180 penetrating the COF packages 170 from the rear side of the COF packages 170, and connectors 190 provided at ends of the COF packages 170 to connect the COF packages 170 to the circuit unit 140. The plasma display device 100 may further include conductive connecting members 150 between the circuit unit 140 and the radiator plates 160.

The plasma display panel 110 includes a front panel 111 and a rear panel 112 mated with the front panel 111.

The front panel 111 includes a front glass substrate disposed in the front thereof and a plurality of scan electrodes and sustain electrodes which are formed on the rear side of the front glass substrate and form pairs to be spaced apart from each other by display gaps. The front panel 111 may further include a front dielectric layer and protection layer to cover the scan electrodes and the sustain electrodes.

The rear panel 112 includes a rear glass substrate disposed at the rear side thereof and a plurality of address electrodes formed on the front side of the rear glass substrate and extending in the direction crossing the scan electrodes and the sustain electrodes. The rear panel 112 may further include a rear dielectric layer to cover the address electrodes, barrier ribs formed on the rear dielectric layer to define discharge spaces, and phosphor layers disposed in the discharge spaces.

The chassis base 120 is disposed at one surface of the plasma display panel 110. The chassis base 120 is made of aluminum, supports the plasma display panel 110 and, radiates heat generated from the plasma display panel 110 to the exterior.

The chassis base 120 further includes bent portions 121 bent backwardly along the edge of the chassis base 120. The bent portions 121 prevent the chassis base 120 from being bent or deflected.

The boss 130 allows the circuit unit 140 to be spaced apart from the chassis base 120 by a distance. The bosses 130 are electrical insulators and thus allow the circuit unit 140 to be electrically separated from the chassis base 120. The bosses 130 are coupled with the couplers 180 to support the radiator plates 160 and the COF packages 170. In order to support the COF packages 170, each of the bosses 130 may be provided to a respective COF 170. This is because the couplers 180 penetrating the COF packages and coupled with the bosses 130 may be provided with as many as the number of the COF packages 170. Thus the number of the bosses 130 is reduced in comparison to an existing structure in which two couplers are coupled with respective two lateral sides of the COF packages 170 so that overall manufacturing costs can be reduced.

The circuit unit 140 is disposed at an opposite surface of the bosses 130 to the chassis base 120. The circuit unit 140 may be insulated from the chassis base 120 by the bosses 130, that is, is electrically separated from the chassis base 120. Also the circuit unit 140 may be electrically connected to the chassis base 120 to receive the ground signal.

The circuit unit 140 includes a plurality of printed circuit boards (PCB) electrically connected to each other to drive the plasma display panel 110. The circuit board 140 may include a power supply board 141, a logic board 142, a sustain electrode driving board 143, a scan electrode driving board 144, and an address electrode driving board 145.

In this case, the scan electrode driving board 144 includes ground signal lines 144a electrically connected to the conductive connecting members 150 and the couplers 180. The ground signal is applied from the scan electrode driving board 144 to the COF packages 170 through the ground signal lines 144a.

Although not depicted in the drawings, the circuit unit 140 may further include a scan buffer board provided at a lateral side of the scan electrode driving board 144 to temporally store data received from the scan electrode driving board 144 and to transmit the same to the scan electrode.

The conductive connecting members 150 are formed at an opposite surface of the circuit unit 140 to chassis base 120. The conductive connecting members 150 are formed between an end of the scan electrode driving board 144 and the radiator plates 160. The conductive connecting members 150 allow the radiator plates 160 to be easily coupled with the scan electrode driving board 144.

The conductive connecting members 150 are electrically connected to the scan electrode driving board 144 and the radiator plate 160. And the conductive connecting member 150 is electrically connected to the COF packages 170 by the couplers 180. Thus, the ground signal transmitted through the scan electrode driving board 144 may be sequentially transmitted to the conductive connecting members 150, the radiator plates 160, and the COF packages 170. In this case, the conductive connecting members 150 maintain the surface contact with the radiator plates 160 such that the ground signal can be easily transmitted to the COF packages 170. For the easy transmission, the conductive connecting members 150 may be made of one a conductive sponge, a copper plate, and a steel plate, or a combination thereof.

The radiator plates 160 are provided at an opposite surface of the conductive connecting members 150 to the circuit unit 140 while maintaining surface contact with the conductive connecting members 150. Thus, radiator plates 160 receive electric connection signals from the conductive connecting members 150 and transmit the electric connection signals to the COF packages 170 through the couplers 180.

The radiator plates 160 extend to regions where scan integrated circuits (IC) 172 are positioned. Thus, the radiator plates 160 absorb heat from the scan ICs 172 and easily radiate the heat.

Each of the radiator plates 160 has a sectional area smaller than that of each of the COF packages 170. The radiator plates 160 are covered with the COF packages 170 so as not to be exposed in the direction which is the coupler 180 is coupled. But the radiator plates 160 are exposed in the direction which faces the chassis base 120. The electric signal applied to the scan ICs 172 may be a ground signal. The ground signal may be a relatively high voltage of -200 V to -150 V. Thus, the radiator plates 160 are covered with the COF packages 170 and are not exposed to the exterior so that a user can be prevented from being exposed to the high voltage. And the radiator plate 160 is contacted to the COF package 170, so it may transmit the ground signal to the COF package 170. Thus, the ground signal of the COF package 170 can be provided stably and the noise of the COF package 170 can be prevented.

The COF packages 170 electrically connect the plasma display panel 110 to the circuit unit 140. Each of the COF packages 170 includes a film 171 as a base and a scan IC 172 formed on the film 170.

Metal traces are patterned in or on each of the films 171. The films 171 transmit electric signals to the scan ICs 172 through the metal traces. Thus, the scan ICs 172 are connected to the scan electrode driving board 144 through the metal traces and apply electric signals to the scan electrodes. Particularly, there is a ground signal line 171a electrically connected to each of the couplers 180, among the metal traces. The ground signal lines 171a may receive the ground signal from the scan electrode driving board 144 through respective electric paths via the couplers 180.

The films 171 are formed at an opposite surface of the radiators 160 to the conductive connecting members 150 and extend to positions corresponding to the bosses 130 of the scan electrode driving board 144. Thus, the films 171 may be fixed to the bosses by the couplers 180. The ground signal lines 171a of the films 171 are electrically connected to the scan electrode driving board 144 through the electrical paths formed by the couplers 180. Thus, the films 171 may steadily receive the ground signals through the paths via the couplers 180.

The films 171 have a structure of wrapping an opposite surface of the radiator plates 160 to conductive connecting members 150, and thus prevent the radiator plates 160 to which the high voltage signals are applied from being exposed so as to protect a user.

The ends of the films 171 are connected to the scan electrode driving board 144 by the connectors 190 so that electric signals different from the signals transmitted through the couplers 180 are transmitted to the films 171 and the scan ICs 172 through the connectors 190.

The sustain electrodes may receive electric signals through COF packages 173 connected to the sustain electrode driving board 143 and the address electrodes may receive electric signals through COF packages 174 connected to the address electrode driving board 145. In this case, each of the COF packages 174 connected to the address electrode driving board 145 may include a film 175 and an integrated circuit (IC) chip 176.

The couplers 180 penetrate the COF packages 170 from the opposite side thereof to the radiate plates 160 and fix the COF packages 170 to the bosses 130. The radiator plates 160 and the COF packages 170 are fixed to the opposite surface of the scan electrode driving board 144 to the chassis base 120.

The couplers 180 form connection paths of electrically connecting the scan electrode driving board 144, the conductive connecting members 150, and the radiator plates 160 to the COF packages 170. The electric signals transmitted to the COF packages 170 via the couplers 180 are transmitted to the scan ICs 172 through the traces of the COF packages 170. Thus, when receiving the electric signals from the scan electrode driving board 144, the scan ICs 172 may receive the electric signals through the paths formed by the couplers 180 in addition to the paths formed by the connectors 190. In this case, the paths form more direct transmission paths than those formed by the connectors 190. Thus, when the electric signals are the ground signals, transmission stability of the ground signals to the scan ICs 172 may be stable in comparison to a case of using the connectors 190.

The connectors 190 are coupled with the ends of the COF packages 170 and are formed above the scan electrode driving board 144. The connectors 190 electrically connect the scan electrode driving board 144 to the films 171 of the COF packages 170 such that the scan electrode driving board 144 and the scan ICs 172 can transmit electric signals to each other. As described above, the ground signals applied to the scan ICs 172 may be applied through the paths formed not by.the connectors 190 but the couplers 180.

By doing as described above, the plasma display device 100 according to the embodiment of the present invention includes the COF packages 170 extended to the opposite surface side of the circuit unit 140 to the chassis base 120 and directly connected to the circuit unit 140 through the radiate plate 160 and/or the couplers 180 such that the ground signals can be transmitted to the COF packages 170 stably and the noise of the COF package 170 can be prevented easily. The radiator plates 160 extending to the lower sides of the scan ICs 172 enable easy radiation of heat from the scan ICs 172 and are covered with the COF packages 170 so as not to be exposed in a direction the coupler 180 is coupled such that a user can be protected from the radiator plates 160 to which the high voltage is supplied.

Although the embodiments of the present invention have been described in detail hereinabove, it should be understood that many variations and modifications of the basic inventive concept herein described will still fall within the scope of the present invention as defined in the appended claims.

## Claims

1. A plasma display device comprising:
a plasma display panel including an electrode;
a chassis base disposed at one surface of the plasma display panel;
a circuit unit separated from an opposite surface of the chassis base to the plasma display panel by a boss and driving the plasma display panel;
a radiator plate provided at an opposite surface of the circuit unit to the chassis base;
a chip-on-film (COF) package formed at an opposite surface of the radiator plate to the circuit unit, electrically connecting the electrode to the circuit unit; and
a coupler penetrating the COF package, the radiator plate, and the circuit unit to couple the same with each other.

2. A plasma display device according to claim 1, wherein the COF package comprises an integrated circuit (IC) to drive the circuit unit and the radiator plate extends to a position where the ICs is located.

3. A plasma display device according to claim 1 or 2, further comprising a conductive connecting member between the radiator plate and the circuit unit.

4. A plasma display device according to claim 3, wherein the conductive connecting member comprises a conductive sponge, a copper plate, a steel plate, or a combination thereof.

5. A plasma display device according to any preceding claim, wherein the circuit unit comprises at least one line electrically connected to the coupler.

6. A plasma display device according to claim 5, wherein the line of the circuit unit connected to the coupler is a ground signal line.

7. A plasma display device according to any preceding claim, wherein each of the COF packages comprises at least one line electrically connected to the couplers.

8. A plasma display device according to any preceding claim, further comprising a connector connected to an end region of the COF package and electrically connected to an opposite surface of the circuit unit to the chassis base.

9. A plasma display device according to any preceding claim, wherein the COF package covers the radiator plates.

10. A plasma display device according to claim 9, wherein the radiator plate is exposed in a direction facing the chassis base.

11. A plasma display device according to any preceding claim, wherein the coupler is coupled with the boss.

12. A plasma display device according to any preceding claim, comprising a plurality of said COF packages and a plurality of said couplers, each said coupler penetrating a respective one of the said COF packages and the said circuit unit, so as to couple the same with each other.

13. A plasma display device according to claim 12, wherein each COF comprises a respective IC and each coupler provides a respective transmission path for electrical signals between the circuit unit and the IC provided on the COF that it penetrates.
